# DEMANDE DE BREVET EUROPEEN

(11) **EP 1 580 298 A1**
(43) Date de publication de la demande: **28.09.2005**
(21) Numéro de dépôt: 04447072.2
(22) Date de dépôt: 22.03.2004
(51) Int. Cl.: C23C 14/35, H01J 37/34

(54) **Dépôt par pulverisation cathodique magnétron en régime impulsionnel avec préionisation**

(71) Demandeur: Materia Nova A.S.B.L, 7000 Mons (BE); CENTRE NATIONAL DE LA RECHERCHE SCIENTIFIQUE, 92192 Meudon (FR); Université de Paris-Sud, 91405 Orsay (FR)
(72) Inventeur: Ganciu-Petcu, Cod 76451 Bucharest (RO); Hecq, Michel, 7000 Mons (BE); Dauchot, Jean-Pierre, 1180 Bruxelles (BE); Konstantinidis, Stephanos, 7000 Mons (BE); Bretagne, Jean, 91470 Limours (FR); De Poucques, Ludovic, 91290 Arpajon (FR); Touzeau, Michel, 91400 Orsay (FR)
(74) Mandataire: Van Malderen, Joelle

(57) **Abrégé**

La présente invention se rapporte au dépôt dans un réacteur magnétron (1) équipé d'une cathode magnétron (CM), au moins un matériau sur un substrat (11a), en vaporisant ledit matériau, par pulvérisation cathodique magnétron, à l'aide d'un gaz qui est ionisé en régime impulsionnel. A cet effet et dans le but de favoriser la formation d'impulsions de courants élevés et de courte durée tout en évitant la formations d'arcs et en permettant une ionisation efficace de la vapeur pulvérisée, on réalise une préionisation dudit gaz préalablement à l'application sur la cathode magnétron (CM) de l'impulsion de tension principale.

## Description

### Objet de l'invention

La présente invention concerne d'une manière générale le dépôt sur un substrat d'un matériau vaporisé par pulvérisation cathodique dans un magnétron. Elle a pour objets un nouveau procédé de dépôt d'au moins un matériau sur un substrat par pulvérisation cathodique magnétron en régime impulsionnel, ainsi qu'une nouvelle alimentation électrique impulsionnelle pour magnétron, et un magnétron équipé de ladite alimentation impulsionnelle.

### Etat de la technique

La technique de dépôt de matériau sur un substrat par pulvérisation cathodique magnétron est connue et s'est développée rapidement depuis les années 1970.

Cette technique de dépôt et ses principaux perfectionnements connus à ce jour sont par exemple décrits dans l'article: « Magnetron sputtering: a review of recent developments and applications » P.J. Kelly, R.D. Arnell, VACUUM 56(2000) pages 159-172.

En résumé, la technique de dépôt d'un matériau sur un substrat par pulvérisation cathodique magnétron consiste d'une manière générale à bombarder une cible, qui forme la cathode d'un réacteur magnétron et qui est réalisée dans le matériau à déposer, avec des ions issus d'une décharge électrique (plasma). Ce bombardement ionique provoque la pulvérisation de la cible sous la forme d'une « vapeur» d'atomes ou molécules qui viennent se déposer, sous forme de couche mince, sur le substrat placé à proximité de la cible du magnétron, le substrat pouvant être fixe ou mobile.

En régime non-réactif, le gaz destiné à former le plasma est un gaz inerte, par exemple l'argon. En régime dit « réactif », on utilise un gaz, généralement dilué dans un gaz inerte, pour générer un composé qui peut selon le cas être ou non électriquement conducteur ; avec une cathode cible en titane, on utilise par exemple comme gaz réactif un mélange d'argon et d'azote, ce qui aboutit à la formation d'un composé de nitrure de titane (TiN), électriquement conducteur, ou un mélange d'argon et d'oxygène, ce qui aboutit à la formation d'un composé de dioxyde de titane (TiO₂) qui est un isolant électrique.

Quel que soit le gaz utilisé, les atomes sont ionisés essentiellement par collisions avec les électrons produits dans la décharge électrique. Au voisinage de la cible est en outre créé un champ magnétique qui permet de piéger les électrons formés dans le gaz, formant ainsi un plasma plus fortement ionisé à proximité de la surface de la cible.

Les procédés de pulvérisation cathodique magnétron sont mis en oeuvre à basse pression (typiquement entre 0,1 Pa et quelques Pa). Il en résulte que les ions ne subissent pas ou peu de collisions au cours de leur trajet vers la cathode cible, ce qui accroît l'efficacité de la pulvérisation. Egalement, cette pression basse permet de faciliter le transport de matière pulvérisée jusqu'au substrat, en réduisant les collisions des atomes ou molécules pulvérisés, et de ce fait en réduisant l'importance des processus de déviation et/ou de perte d'énergie cinétique des particules (atomes ou molécules) pulvérisées.

La technique précitée de dépôt de matériau sur un substrat par pulvérisation cathodique magnétron est particulièrement adaptée pour réaliser le dépôt, essentiellement en couches minces, d'une grande variété de matériaux dans des domaines d'application très variés tels que la microélectronique (dépôts métalliques d'interconnexion et de diélectriques pour les structure MOSFET), l'optoélectronique (fabrication de substrats piézo-électriques), la mécanique ou connectique (dépôts de revêtement anti-usure, anticorrosion, ...), l'industrie du verre (couches fonctionnelles). Les matériaux déposés peuvent être des matériaux métalliques ou composés électriquement conducteurs, des céramiques isolantes du type nitrures, oxydes, carbures, oxynitrures, etc.

Comparativement aux autres techniques connues de dépôt par évaporation (procédé d'évaporation et de dépôt par voie thermique, notamment par chauffage inductif, ou procédé de dépôt par évaporation sous faisceau d'électrons ou par arc), la pulvérisation cathodique magnétron présente l'avantage d'être plus directionnelle, en raison de l'existence d'un lobe d'émission, plus ou moins ouvert, perpendiculaire à la cathode cible, avec des vitesses d'éjection des particules pulvérisées qui peuvent avantageusement être plus importantes.

A l'origine, dans la technique précitée de dépôt par pulvérisation cathodique magnétron, les décharges électriques dans le plasma étaient réalisées en régime permanent en appliquant sur la cathode une tension continue ou par une excitation Radio-Fréquences (RF) du gaz.

D'une manière générale, les limitations de la technique de pulvérisation cathodique magnétron en régime permanent sont liées à une qualité généralement insuffisante des couches déposées, particulièrement en ce qui concerne la porosité, et à la difficulté d'obtenir des dépôts homogènes sur des substrats présentant une surface de dépôt à géométrie complexe, et à des vitesses de dépôt qui restent relativement faibles (typiquement de l'ordre du *µ*m/h). Plus particulièrement, s'agissant de la qualité des couches déposées, on observe souvent en régime permanent (DC ou RF) la formation intempestive d'arcs électriques, qui provoquent l'éjection de matière en provenance de la cible sous la forme de gouttelettes, lesquelles gouttelettes se déposent sur le substrat en créant de manière préjudiciable des défauts dans le revêtement.

Au surplus, dans le cas du dépôt de matériaux isolants par pulvérisation cathodique magnétron, l'utilisation d'une excitation RF seule reste relativement complexe et il est difficile de contrôler le procédé. De plus, les taux de pulvérisation sont considérablement réduits.

Pour améliorer le dépôt par pulvérisation cathodique magnétron de matériaux isolants, et en particulier d'oxydes tel que l'alumine, on a déjà proposé de pulser la décharge magnétron (voir article précité de P.J. Kelly, R.D. Arnell, pages 166 à 168 / section 7 intitulée « Pulsed magnetron sputtering »). Ainsi, selon cette technique en régime impulsionnel, on applique sur la cathode magnétron des impulsions de tension, dans le but de créer dans le gaz plasma un courant de décharge impulsionnel (impulsions de courant) permettant d'ioniser le gaz et former un plasma (dit par la suite plasma « principal ») fortement ionisé.

En particulier, dans cet article, il est indiqué qu'en pulsant la décharge magnétron à des fréquences supérieures à 20 kHz, et en particulier dans la gamme de fréquences. 20kHz - 100kHz, il serait possible d'éviter la formation d'arcs électriques, provoqués par un empoisonnement de la cible (« target poisoning ») par une couche isolante. Les vitesses de dépôt sont également améliorées (de l'ordre d'une dizaine de *µ*m/h).

Il est également précisé dans cet article que la durée de l'impulsion « On » doit être limitée pour réduire suffisamment l'empoisonnement de la cible à l'origine des arcs électriques, et que durant l'impulsion « Off », la charge électrique de surface est neutralisée.

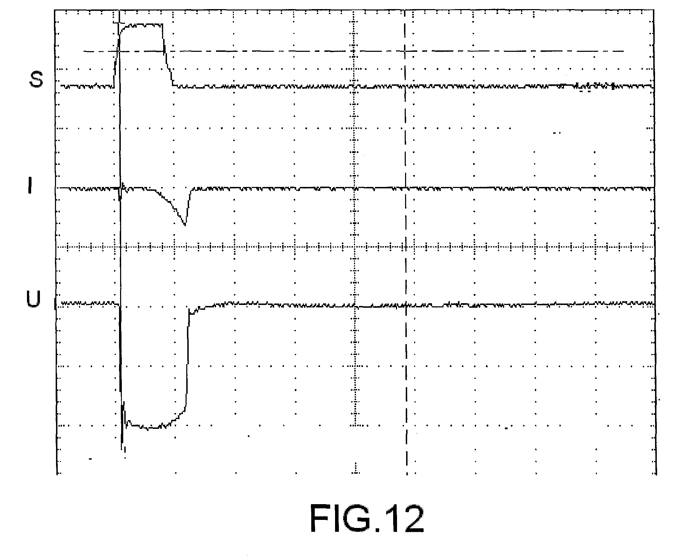

Plus particulièrement, il est précisé que la suppression des arcs électriques la plus efficace est observée lorsque la durée des impulsions « Off » approche ou est égale à la durée des impulsions « On ». Dans l'exemple de réalisation donné (figure 12), la durée des impulsions « Off » représente environ 10% du cycle total, et vaut 5*µ*s, la durée des impulsions « On » valant 45µs. Dans ces conditions, le courant moyen n'est que légèrement inférieur (de 10 %) au courant impulsionnel.

Plus récemment, il a été proposé, notamment dans le brevet US 6,296,742 (Kousnetsov) d'améliorer la technique de dépôt par pulvérisation cathodique magnétron en régime impulsionnel permettant une ionisation efficace de la vapeur pulvérisée, en utilisant des impulsions présentant une puissance instantanée très élevée (0,1kW-1MW) et générées de telle sorte que le gaz (plasma) localisé à proximité de la cathode atteigne rapidement un état de forte ionisation (plage de fonctionnement S8 de la figure 1 du brevet US 6,296,742).

Il est expliqué dans le brevet US 6,296,742 que cette solution permettrait d'appliquer une tension élevée à la cathode tout en évitant la formation d'arc électrique. En pratique, on constate que la mise en oeuvre de cette solution s'accompagne de la formation d'arcs électriques préjudiciables à la qualité des dépôts. Ces apparitions intempestives d'arcs électriques peuvent s'expliquer par le fait que le gaz, avant d'atteindre un état de forte ionisation doit passer par une région de décharge d'arc (région S7 de la figure 1 du brevet US 6,296,742). Les demanderesses ne sont toutefois pas liées par cette explication.

Avec la technique de dépôt par pulvérisation cathodique magnétron en régime impulsionnel, si l'on souhaite augmenter la puissance instantanée des décharges électriques produites dans le gaz, il convient d'appliquer sur la cathode des impulsions de tension qui sont les plus courtes possibles (typiquement inférieures à 50µs, plus particulièrement inférieures à 20*µ*s, et de préférence inférieures à 5µs). On constate en effet qu'en réduisant la durée des impulsions de tension, on diminue les risques de formation intempestive d'arcs électriques.

Les inventeurs ont toutefois mis en évidence que la réduction de la durée des impulsions de tension appliquées à la cathode engendrait deux inconvénients préjudiciables à la formation des impulsions de courant dans le gaz. Ces deux inconvénients sont liés au temps de retard de la formation de l'impulsion de courant par rapport à l'impulsion de tension, c'est-à-dire à la durée qui s'écoule entre l'application sur la cathode magnétron de l'impulsion de tension, et le début de formation de l'impulsion de courant dans le gaz. Ce temps de retard est lié au temps de développement de l'avalanche électronique.

### 1^{er} inconvénient : temps de retard trop important

Dans le pire des cas, il arrive que le temps de retard précité soit supérieur à la durée de l'impulsion de tension. Dans ce cas, l'impulsion de courant ne se forme pas. Si ce temps de retard est plus faible que la durée de l'impulsion de tension, mais est tel que l'impulsion de courant n'a pas le temps de se développer correctement avant la fin de l'impulsion de tension, on aboutit à la formation d'une impulsion de courant de faible amplitude, et par là-même, de manière préjudiciable, à la formation d'une décharge électrique de faible puissance. En résumé, plus le temps de retard est important par rapport à la durée de l'impulsion de tension, et plus l'amplitude de l'impulsion de courant est faible (et est même quasi nulle en cas de temps de retard supérieur à la durée de l'impulsion de tension).

### 2^{nd} inconvénient : fluctuation du temps de retard

Le second inconvénient est une fluctuation importante du temps de retard, ce qui se traduit par une instabilité, et une mauvaise reproductibilité dans le temps de la formation des impulsions de courant. Cet inconvénient rend le processus de dépôt aléatoire et non reproductible.

### Buts de l'invention

La présente invention vise à améliorer les procédés connus de dépôt d'un matériau par pulvérisation cathodique magnétron en régime impulsionnel, en proposant une nouvelle solution qui permet de pallier les deux inconvénients précités, tout en permettant une ionisation efficace de la vapeur pulvérisée,...

Plus particulièrement, l'invention vise à proposer un procédé de dépôt d'un matériau par pulvérisation cathodique magnétron en régime impulsionnel, qui permet de générer des décharges électriques, de préférence de forte puissance, avec une bonne stabilité et une bonne reproductibilité dans le temps, tout en réduisant le risque de formation d'arcs électriques.

### Résumé de l'invention

Les objectifs précités sont atteints par le procédé de la revendication 1. Ce procédé est connu en ce qu'on dépose, dans un réacteur magnétron équipé d'une cathode magnétron, au moins un matériau sur un substrat, en vaporisant ledit matériau par pulvérisation cathodique magnétron, et à l'aide d'un gaz qui est ionisé (plasma principal) en régime impulsionnel en appliquant sur la cathode magnétron des impulsions de tension principales.

De manière caractéristique selon l'invention, préalablement à chaque impulsion de tension principale, on réalise une préionisation dudit gaz en sorte de favoriser (stabiliser et/ou accélérer) la formation de l'impulsion de courant.

Cette préionisation du gaz avant chaque impulsion de tension principale aboutit à la création, dans le réacteur magnétron, d'un plasma initial qui permet avantageusement de diminuer le temps de retard de l'impulsion de courant par rapport à l'impulsion de tension principale, et de rendre ce temps de retard moins fluctuant. Comparativement à un procédé sans préionisation, on génère ainsi des décharges électriques de plus forte puissance instantanée, et avec une puissance instantanée relativement constante dans le temps.

Cette préionisation est particulièrement avantageuse dans un régime de fonctionnement impulsionnel avec des impulsions de tension principales courtes, ce qui permet en outre avantageusement de réduire la probabilité de formation intempestive d'arcs électriques.

Un autre rôle de la préionisation est de créer dans le magnétron, entre la cathode et le substrat, une densité d'électrons libres suffisante qui favorise le transport vers le substrat des vapeurs de matériau ionisées.

Un autre avantage important du procédé de l'invention est l'obtention d'une ionisation élevée des vapeurs arrivant sur le substrat. Grâce à la préionisation, on obtient un taux d'ionisation des vapeurs arrivant sur le substrat qui est supérieur à 10% et de préférence supérieur à 70%. Ce taux d'ionisation est mesuré au voisinage du substrat par une méthode de spectroscopie par absorption du type de celle décrite dans l'une ou l'autre des deux publications ci-après :
- S. Konstantinidis, A. Ricard, M. Ganciu, J.-P. Dauchot, M. Wautelet, and M.Hecq, "A study of an ionized magnetron source by pulsed absorption spectroscopy" Proceedings of the 46th Annual Technical Conférence of the Society of Vacuum Coaters, published by the Society of Vacuum Coaters, Albuquerque, NM, USA (2003) 452 ;
- O.Leroy, L.de Poucques, C.Boisse-Laporte, M.Ganciu, L.Teulé-Gay, M.Touzeau "Détermination of titanium température and density in a magnetron vapor sputtering device assisted by two microwave coaxial excitation systems" J. of Vacuum Science & Technology A: Vacuum, Surfaces, and Films, 22 (2004) 192

L'obtention, grâce à l'invention, d'un taux élevé d'ionisation des vapeurs arrivant sur le substrat permet avantageusement d'améliorer la qualité des couches déposées sur le substrat (notamment meilleure adhérence et meilleure compacité des couches déposées).

Un autre avantage de la mise en oeuvre d'une préionisation selon l'invention est d'assurer un conditionnement de la surface du substrat (pré dépôt, ablation, polarisation) qui permet la modulation des propriétés des couches déposées (adhérence, structure, uniformité) en fonction des applications envisagées. Cet avantage est par exemple particulièrement intéressant dans le domaine de la microélectronique.

Selon l'invention, la préionisation du gaz avant chaque impulsion de tension principale peut être obtenue de plusieurs manières différentes.

Dans une première variante de réalisation, la préionisation du gaz est obtenue en appliquant sur la cathode magnétron une tension de préionisation. Cette tension de préionisation est de préférence continue, mais peut également être pulsée, l'essentiel étant que la préionisation du gaz (formation du plasma initial) soit effective avant l'application de l'impulsion de tension principale pour la formation du plasma principal.

Dans une deuxième variante de réalisation, la préionisation du gaz est obtenue par excitation RF du gaz.

Dans une troisième variante de réalisation, la préionisation du gaz est obtenue par une excitation micro-ondes du gaz ou par tout autre moyen permettant de créer une densité de charges libres suffisante dans l'espace situé entre la cathode et l'anode. Par exemple, pour la zone magnétisée qui fait face à la cathode, cette densité (estimée à l'aide de la relation entre la densité électronique et la densité du courant ionique extraite du plasma) est de préférence supérieure 10⁸cm⁻³ et plus préférentiellement encore supérieure à 10⁹ cm⁻³.

Dans une quatrième variante, la préionisation peut être assurée par une fréquence de répétition des impulsions suffisamment élevée pour former une impulsion de courant stable à chaque impulsion de tension, de manière à utiliser la densité électronique résiduelle entre deux impulsions successives.

Dans le cadre de l'invention, les impulsions de tension principales pour la formation du plasma principal peuvent être appliquées sur la cathode magnétron dans un régime de type mono-imupulsion ou dans régime de type de pluri-impulsion, c'est-à-dire en étant engendrées par trains successifs d'au moins deux impulsions rapprochées.

De préférence, quelle que soit la manière de réaliser la préionisation du gaz, et quel que soit le régime impulsionnel (mono ou pluri-impulsion) la durée des impulsions de tension principales est inférieure à 50 µs, plus particulièrement inférieure à 20*µ*s, et de préférence comprise entre 1*µ*s et 10*µ*s. Plus particulièrement, la fréquence des impulsions (régime mono impulsion) ou des trains d'impulsions rapprochées est inférieure ou égale à 100kHz, et est de préférence supérieure à 50 Hz.

L'invention a également pour autres objets une nouvelle alimentation électrique impulsionnelle pour réacteur magnétron, ainsi qu'un réacteur magnétron équipé de cette alimentation électrique impulsionnelle.

L'alimentation électrique impulsionnelle de l'invention comporte:
- une sortie destinée à être raccordée à la cathode (CM) d'un réacteur magnétron,
- des premiers moyens permettant de générer sur la sortie (Out) des impulsions de tension principales, et
- des deuxièmes moyens permettant de générer une tension de préionisation sur la sortie simultanément aux impulsions de tension principales.

### Brève description des figures

D'autres caractéristiques et avantages de l'invention apparaîtront plus clairement à la lecture de la description ci-après de plusieurs variantes de mise en oeuvre du procédé de l'invention, laquelle description est donnée à titre d'exemple non exhaustif et non limitatif de l'invention, et en référence aux figures annexées sur lesquelles:

La figure 1 représente représente de manière schématique un réacteur magnétron équipé d'une alimentation impulsionnelle de l'invention.

La figure 2 est un schéma électrique d'un exemple de réalisation d'une alimentation électrique impulsionnelle de l'invention.

La figure 3 représente de manière schématique des oscillogrammes respectivement de la tension (U) mesurée sur la cathode magnétron et du courant (I) traversant la cathode magnétron, dans un régime de fonctionnement.du type mono-impulsion.

Les figures 4 à 17 sont des oscillogrammes réels du signal de commande (S), de la tension (U) et du courant (I) précités, obtenues par capture d'écran d'un oscilloscope dans différentes conditions de fonctionnement décrites en détail ultérieurement.

La figure 18 représente de manière schématique une autre variante de réalisation d'un réacteur magnétron de l'invention, avec boucle RF pour la préionisation.

### Description détaillée de l'invention

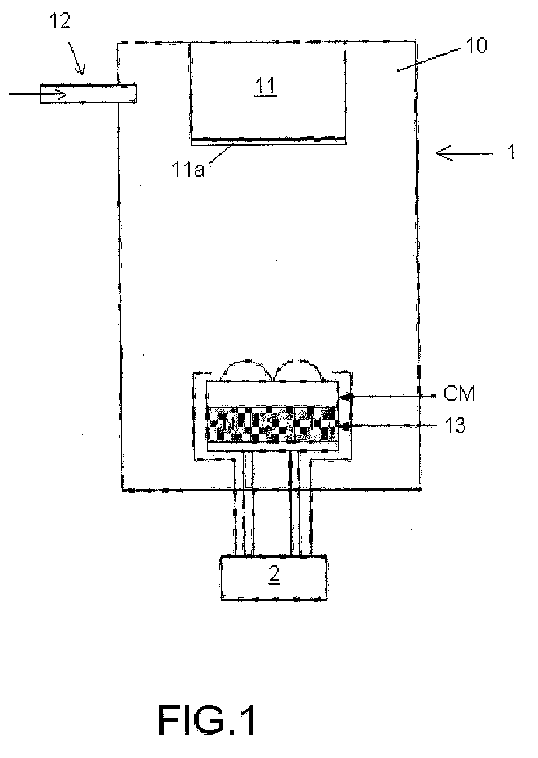

### Schéma de principe du réacteur magnétron (1) / Figure 1

On a représenté sur la figure 1, le schéma de principe d'un réacteur magnétron 1 équipé d'une alimentation électrique impulsionnelle 2 qui est conforme à l'invention.

Le réacteur magnétron 1 est connu en soi. Sa structure et son fonctionnement général sont succinctement rappelés.

Le réacteur magnétron 1 comporte essentiellement, et de manière connue en soi, une enceinte de dépôt 10 à l'intérieur de laquelle est montée une cathode CM, dite par la suite cathode magnétron. Au droit et à distance de cette cathode magnétron CM est monté un porte-substrat 11 destiné à recevoir un substrat 11a. L'enceinte 10 est en outre équipée d'un système d'admission 12 pour l'introduction d'un gaz ou mélange de gaz, qui une fois ionisé formera un plasma. La cathode magnétron est constituée par un échantillon du matériau que l'on souhaite déposer sous forme de couches minces sur le substrat 11a.

D'une manière générale, et de manière connue en soi, l'alimentation 2 permet en fonctionnement d'appliquer sur la cathode magnétron CM une tension négative qui engendre au sein du gaz de l'enceinte de dépôt 10 des décharges électriques se traduisant par la formation d'un courant de décharge passant par la cathode magnétron CM, et par une ionisation forte du gaz (formation d'un plasma principal). Les ions de ce plasma principal viennent bombarder la surface (cible) de la cathode magnétron CM avec des vitesses suffisamment élevées pour pulvériser en surface la cathode magnétron CM. Il se forme ainsi au sein de l'enceinte 10 une vapeur du matériau constitutif de la cathode CM, laquelle vapeur de matériau vient se déposer en couches minces à la surface du substrat 11a.

Au niveau de la face inférieure de la cathode CM sont en outre prévus des aimants 13 qui créent un champ magnétique permanent ayant pour fonction principale de capter et de confiner les électrons du plasma principal au voisinage de la cathode magnétron. Ce champ magnétique permet ainsi de former et de maintenir un plasma magnétisé plus fortement ionisé au voisinage de la cathode magnétron CM.

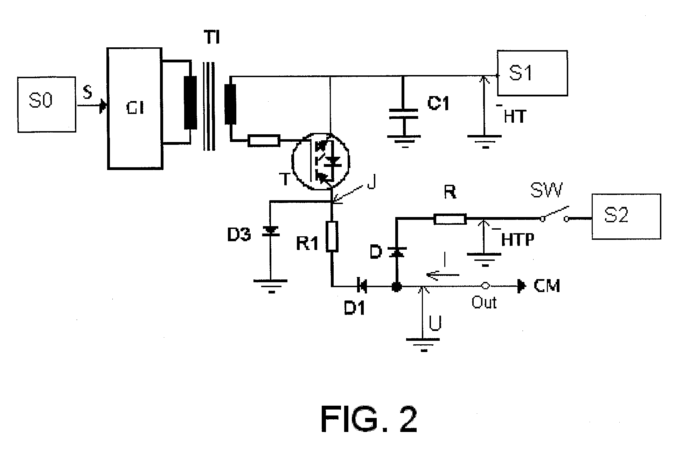

### Structure de l'alimentation électrique (2) / Figure 2

La figure 2 représente le schéma électrique d'un exemple de réalisation d'une alimentation électrique impulsionnelle 2. conforme à l'invention.

L'alimentation électrique utilisée dans l'invention est conçue de manière à permettre d'utiliser les avantages d'une préionisation continue ou pulsée.

L'alimentation 2 comporte une sortie (Out) qui est raccordée (de manière connue en soi) à la cathode CM du réacteur magnétron, des premiers moyens (S0, GI, TI, T, S1, C1, R1, D1, D3) permettant de générer sur le sortie (Out) des impulsions de tension principales, et des deuxièmes moyens (S2, R, D) permettant de générer une tension de préionisation sur la sortie (Out) simultanément aux impulsions de tension principales.

Plus particulièrement, dans l'exemple de réalisation illustré sur la figure 2, les premiers moyens précités pour la génération des impulsions de tension principales comportent:
- une source de tension continue S1 (délivrant en sortie une tension négative HT),
- des moyens (S0, G1, T1) de génération d'impulsions de commande,
- des moyens de commutation T qui sont montés entre la source de tension continue S1 et la sortie (Out),
- une résistance R1 et une diode de séparation D1 qui sont montés en série entre les moyens de commutation Tl et la sortie (Out).

La jonction J entre les moyens de commutation T et la résistance R1 est en outre reliée à la masse, via une diode de séparation D3. La sortie de la source de tension S1 est également reliée à la masse au moyen d'une capacité C1.

Les moyens de génération d'impulsions de commande comportent plus particulièrement:
- une alimentation S0 délivrant un signal de commande S, de type rectangulaire, de fréquence et de rapport cyclique réglables,
- un générateur d'impulsions (GI) déclenché par le signal de commande (S),
- un transformateur d'impulsion pour la commande du moyen de commutation T.

Plus particulièrement, dans l'exemple illustré, le moyen de commutation T est un transistor à jonction bipolaire du type IGBT, dont la grille est couplée au générateur d'impulsions GI, au moyen du transformateur d'impulsions TI.

La source de tension continue S1 permet, uniquement lorsque le transistor T est passant, d'appliquer une tension négative sur la cathode magnétron CM, via la résistance R1 et la diode de séparation D1 montées en série avec la cathode CM.

Les deuxièmes moyens précités pour la génération de la tension de préionisation comportent une source de tension continue S2 reliée à la sortie (Out) via une résistance R et une diode de séparation D en série. La source de tension S2 délivre en sortie une tension continue de préionisation négative (HTP).

Un interrupteur SW est en outre monté en série avec la sortie de la source de tension S2. Lorsque l'interrupteur SW est fermé, la tension négative de préionisation (HTP) est appliquée sur la cathode magnétron CM, via la résistance R et la diode D de séparation.

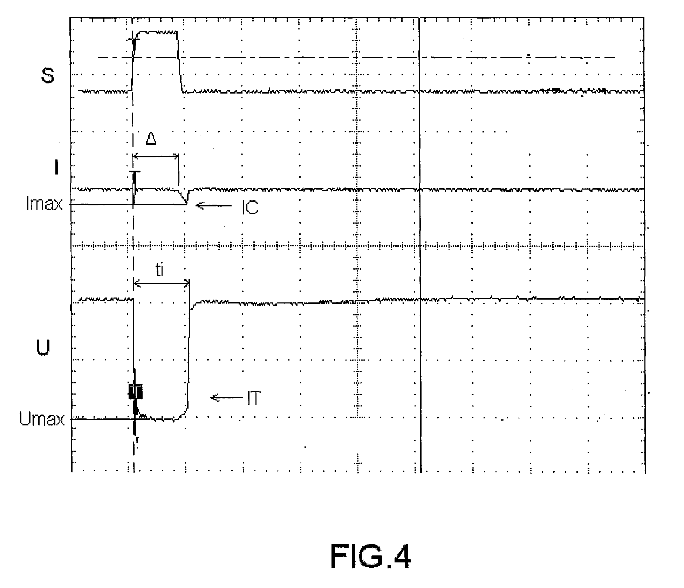

L'interrupteur SW précité est facultatif et est utilisé essentiellement pour pouvoir réaliser des essais comparatifs (voir ci-après la description des figures 4 et suivantes) entre:
- [interrupteur (SW) ouvert] / un fonctionnement du réacteur magnétron 1 en un régime impulsionnel seul (fonctionnement classique) et,
- [interrupteur (SW) fermé] / un fonctionnement conforme à l'invention, avec superposition, sur le régime impulsionnel, d'un régime permanent permettant d'obtenir la préionisation requise du gaz (en l'espèce, application d'une tension négative continue de préionisation sur la cathode magnétron (CM)).

Pour réaliser une alimentation conforme à l'invention, on pourra remplacer le transistor T qui dans l'exemple de la figure 2 est un transistor IGBT, par tout moyen équivalent connu de l'homme l'art, c'est-à-dire par tout moyen de commutation rapide commandé par un signal électrique. Le transistor T peut, par exemple, et de manière non exhaustive, être remplacé par un commutateur de type Behlke.

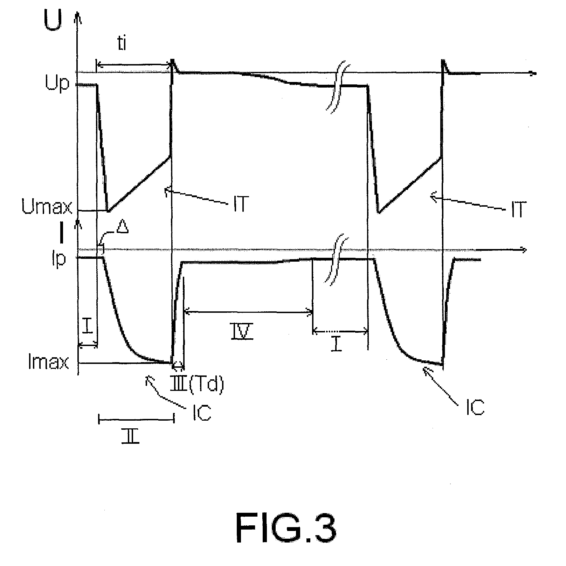

### Fonctionnement de l'alimentation (2) / Figures 2 et 3

Le fonctionnement de l'alimentation 2 va à présent être expliqué en référence à la figure 2 et également en référence à la figure 3. La figure 3 représente de manière schématique un exemple d'oscillogrammes de la tension (U) mesurée entre la cathode magnétron CM et la masse, et du courant de décharge (I) traversant la cathode magnétron CM. Pour la description des phases de fonctionnement (I à IV) ci-après, on considère que l'interrupteur (SW) de l'alimentation 2 est fermé.

### Phase I / Pré- ionisation (figure 3) :

Le transistor T est bloqué. Seule la tension négative de préionisation (HTP) est appliquée sur la cathode magnétron CM, via la résistance de limitation de courant R. Cette tension continue négative génère au sein du gaz une décharge électrique continue se traduisant par un courant de préionisation continu Ip qui passe par la cathode magnétron CM, la diode de séparation D et la résistance R.

### Phase II :

A l'issue de la première phase (I) de préionisation, la grille du transistor T est commandée par le générateur d'impulsions GI (transistor T passant), ce qui permet d'appliquer temporairement la tension négative (HT) sur la cathode magnétron CM via la résistance de limitation de courant R1 et la diode de séparation D1. On applique ainsi sur la cathode CM une impulsion de tension IT principale, de durée ti, ce qui se traduit par une impulsion de courant principale IC traversant la cathode magnétron CM. Cette impulsion de courant principale IC est générée avec un temps de retard faible Δ, par rapport au début de l'impulsion de tension IT.

### Phase III :

Le transistor (T) est de nouveau bloqué (commutation inverse du transistor par le générateur d'impulsion GI). La haute tension négative HT n'est plus appliquée sur la cathode magnétron CM (fin de l'impulsion de tension principale). Le courant (I) reste soutenu seulement par l'énergie inductive accumulée dans l'inductance équivalente (L) du réacteur magnétron 1. Le courant (I) diminue avec une constante de temps sensiblement égale à [L / (RE)] où RE est une résistance série équivalente limitée inférieurement par la valeur de la résistance R1. La différence entre RE et R1 est liée à l'impédance non linéaire du plasma. La diode D3 (figure 2) assure le passage du courant (I) après la commutation du transistor T, en évitant en même temps des surtensions sur ce transistor.

### Phase IV :

Après l'arrêt du courant impulsionnel, l'impédance du réacteur magnétron 1 reste basse du fait de l'état de forte ionisation du plasma magnétisé. En conséquence, pour le même courant continu de préionisation (Ip), la tension (U) sur la cathode magnétron reste basse pendant quelques temps. Au fur et à mesure que l'état d'ionisation du plasma magnétisé décroît, l'impédance du réacteur magnétron 1 augmente, et on revient progressivement aux conditions initiales de la phase (I) préionisation précitée.

Le cycle est repris avec une fréquence de répétition (f) qui est fixée en fonction de l'application envisagée.

### Choix de R1, C1 et R.

Le choix de la résistance R1 est important pour un bon fonctionnement de l'alimentation 2. Ce choix est effectué en sorte de respecter les deux contraintes opposées suivantes :
- La durée (Td) de décroissance de l'impulsion de courant IC au cours de la phase (III) (voir figure 3) doit être la plus faible possible (comparativement à la durée ti des impulsions de tension principales IT). En pratique, on cherche à obtenir une durée (Td) de décroissance inférieure à 5*µ*s, et de préférence inférieure ou égale 1*µ*s, ce qui correspond sensiblement au choix d'un rapport (L/R1) inférieur à 2,5*µ*s, et de préférence inférieur ou égal à 0,5µs. Cette contrainte permet ainsi de fixer la valeur minimale de la résistance R1 appropriée pour une inductance équivalente L donnée du réacteur magnétron 1 et des conducteurs de liaison.
- La résistance (R1) ne doit pas être trop élevée afin de limiter le courant maximal (Imax/ figure 3) généré au cours de la phase II ; en pratique on choisira (R1) de telle sorte que ce courant (Imax) soit dans tous les cas inférieur, par exemple, à deux fois le courant maximum de fonctionnement du réacteur magnétron, afin d'éviter tout risque de fonctionnement anormal du réacteur magnétron.

De préférence, l'alimentation est réglée de telle sorte que l'une et/ou l'autre des conditions suivantes soient respectées:
- la densité maximum de courant de préionisation (au niveau de la cible, c'est-à-dire cathode magnétron) est comprise entre 0,05 mA/cm² et 100 mA/cm² ;
- la densité maximum de courant (au niveau de la cible) est supérieure à 0,1A/cm², et de préférence supérieure à 1A/ cm² ;
- le temps de montée du courant est inférieur à 20*µ*s et plus particulièrement inférieur à 1µs ;
- une durée (Td) de décroissance (temps de coupure du courant) inférieure à 5*µ*s, et de préférence inférieure ou égale 1*µ*s

La capacité (C1), de faible inductance série, est choisie en sorte d'obtenir au cours de la phase II précitée un courant impulsionnel tout en maintenant une haute tension convenable (U) sur la cathode magnétron (CM) pendant l'impulsion appliquée.

La résistance (R) est choisie en sorte de définir et de limiter le courant de préionisation initial.

Dans un exemple précis de réalisation donné à titre indicatif et non limitatif de l'invention, la tension (HT) valait au maximum -1100 V. La tension (HTP) valait au maximum -1100V L'inductance équivalente (L) du réacteur magnétron 1 valait approximativement 0,5µH. La résistance R1 valait 5Ω, de telle sorte que (Td) valait environ 0,1µs. La résistance R valait 300kΩ. La capacité C1 valait 10 µF.

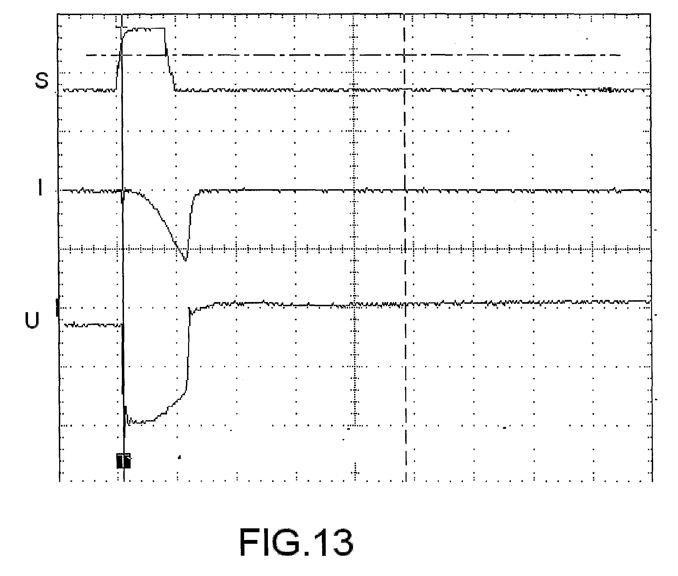

### Essais comparatifs : régime impulsionnel sans préionisation régime impulsionnel avec préionisation (figures 4 à 17)

Des essais comparatifs ont été effectués avec le réacteur magnétron 1 et l'alimentation 2 précédemment décrits en référence aux figures 1 à 3, dans le but de mettre en évidence les effets avantageux de la préionisation sur la formation de l'impulsion de courant IC au cours de la phase II, en particulier sur le temps de retard (Δ) de l'impulsion de courant, sur son intensité maximale Iₘₐₓ, et sur la stabilité dans le temps des impulsions de tension IT et de courant IC.

Les principales conditions communes à tous les essais étaient les suivantes: le gaz utilisé pour former le plasma était l'argon; la cathode (cible) était en titane. La pression à l'intérieur de l'enceinte (10) du réacteur magnétron valait 10mTorr (soit environ 1,33Pa).

Pour chaque essai, les trois signaux ci-après ont été capturés simultanément au moyen d'un oscilloscope (voir figures 4 à 17)
- (S) : impulsion de commande délivrée par le générateur S0
- (I) : courant traversant la cathode magnétron (CM)
- (U) : tension mesurée entre la cathode magnétron (CM) et la masse.

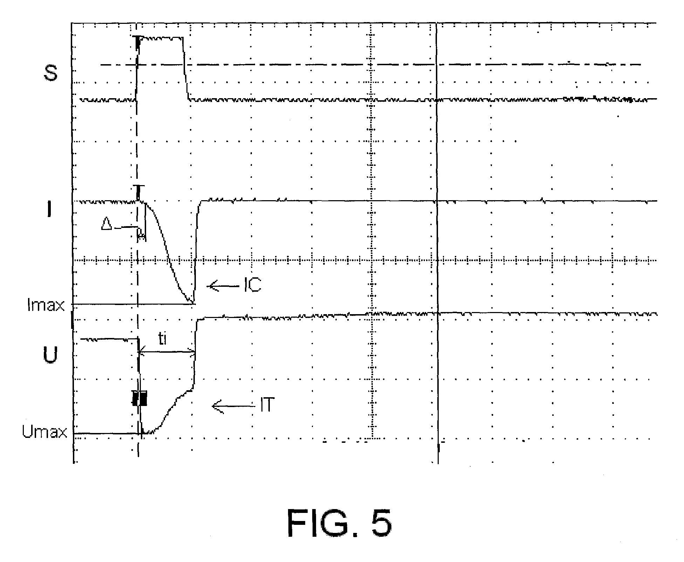

Les essais ont été effectués à chaque fois de manière comparative [voir colonne (2) du tableau ci-après]:
- sans appliquer de tension de préionisation [interrupteur (SW) ouvert) / figures 4, 6, 8, 10, 12, 14, 16], et
- en appliquant une tension continue de préionisation (HTP) [interrupteur (SW) fermé) / figures. 5, 7, 9, 11, 13, 15, 17] .

Pour tous les essais avec préionisation, la tension continue (HTP) de préionisation valait -1000V, et le courant continu (Ip) de polarisation valait environ 3,3mA. Il convient de noter que du fait de l'importance de l'échelle utilisée pour mesurer le courant (I), le courant de préionisation (Ip) de très faible valeur n'est pas visible sur les oscillogrammes des figures 5, 7, 9, 11, 13, 15, 17.

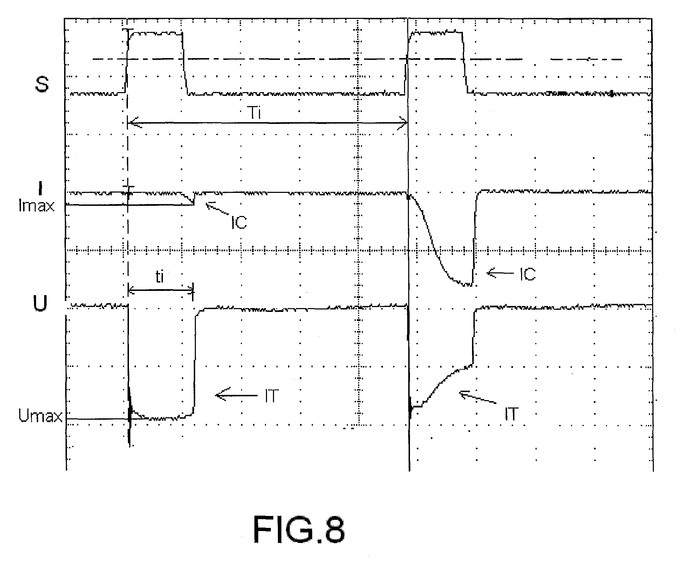

Les essais comparatifs ont été effectués en régime mono-impulsionnel) (figures 4 à 7 et figures 12 et 13), et en régime de double impulsion (figures 8 à 11 et figures 14 à 17), c'est-à-dire en générant des trains successifs de deux impulsions de tension IT rapprochées.

Les principaux paramètres variables et résultats de ces essais sont résumés dans le tableau ci-après. Dans ce tableau, la durée (ti) [colonne (4)] correspond à la largeur de chaque impulsion de tension principale IT ; la durée (Ti) [colonne (5)] correspond, dans le cas d'un régime de double impulsion (c'est-à-dire une succession de trains de deux impulsions de tension rapprochées), à la durée séparant les deux impulsions d'un train d'impulsions ; la fréquence (f) [colonne (6)] correspond à la fréquence de répétition des impulsions de tension IT (en cas de régime mono-impulsionnel) ou de répétition des trains de deux impulsions rapprochées IT dans le cas d'un régime de double impulsion ; le temps de retard Δ [colonne (7)] mesure le temps séparant le début de l'impulsion de courant IC par rapport au début de l'impulsion de tension IT. Les valeurs Imax et Umax reportées dans le tableau ci-après (colonnes (8) et (9)) correspondent à l'amplitude maximale respectivement de l'impulsion de courant et de l'impulsion de tension ; dans le cas des essais en régime de double impulsion, ces amplitudes (Imax et Umax) sont mesurées sur la première impulsion du train de deux impulsions.

| Tableau / Résultats comparatifs : | | | | | | | | |
|---|---|---|---|---|---|---|---|---|
| (1) | (2) | (3) | (4) | (5) | (6) | (7) | (8) | (9) |
| Figure # | Préionisation ? | Régime | Durée (ti) en µs | Durée (Ti) en µs | Fréquence (f) en Hz | Temps de Retard Δ en µs | Iₘₐₓ en A | Umax en V |
| 4 | NON | Mono Imp. | **10** | / | **50** | / | **10** | **-1000** |
| 5 | **OUI** | Mono Imp. | 10 | / | 50 | << Δ(FIG4) | **90** | **900** |
| 6 | NON | Mono Imp. | 10 | / | **100** | **3,6** | **80** | **-1000** |
| 7 | **OUI** | Mono Imp. | 10 | / | 100 | **1,2** | **75** | **- 900** |
| 8 | NON | Double Imp. | 10 | **48** | **50** | **/** | **10** | - **950** |
| 9 | **OUI** | Double Imp. | 10 | 48 | 50 | 1 | **90** | **-1000** |
| 10(*) | NON | Double Imp | 10 | 48 | 50 | 1 | **20** | **-1000** |
| **11(*)** | **OUI** | Double Imp | 10 | 48 | 50 | / | **90** | **-1000** |
| 12 | NON | Mono Imp | **5** | / | 50 | 1 | **30** | **-1000** |
| **13** | **OUI** | Mono Imp | 5 | / | 50 | << Δ(FIG12) | **60** | **-1000** |
| 14 | NON | Double Imp | 5 | **23,8** | **100** | (**) | **0** | **-1000** |
| **15** | **OUI** | Double Imp | 5 | 23,8 | 100 | / | **60** | **-1000** |
| 16(*) | NON | Double Imp | 5 | 23,8 | 100 | (**) | **0** | **-1000** |
| 17(*) | **OUI** | Double Imp | 5 | 23,8 | 100 | / | **60** | **-1000** |

| | | | | | | | | |
|---|---|---|---|---|---|---|---|---|
| (*) Oscilloscope en mode enveloppe (**) Pas de première impulsion de courant | | | | | | | | |

L'analyse des figures 4 et 5 fait clairement apparaître qu'en absence de préionisation (figure 4), l'impulsion de courant présente un temps de retard important par rapport à l'impulsion de tension, ce qui se traduit par une impulsion de courant de très faible amplitude, alors que dans les mêmes conditions de fonctionnement avec préionisation (figure 5), on obtient une impulsion de courant nettement plus rapidement (Δ très faible), et de ce fait avec une amplitude importante. La puissance des décharges électriques générées au sein du gaz est donc, de manière avantageuse, nettement plus importante dans le cas d'un fonctionnement en régime impulsionnel avec préionisation. Dans certains cas, en l'absence de préionisation, on peut même aboutir à un temps de retard (Δ) supérieur à la largeur (ti) de l'impulsion de tension, ce qui se traduit par l'absence quasi-totale d'impulsion de courant.

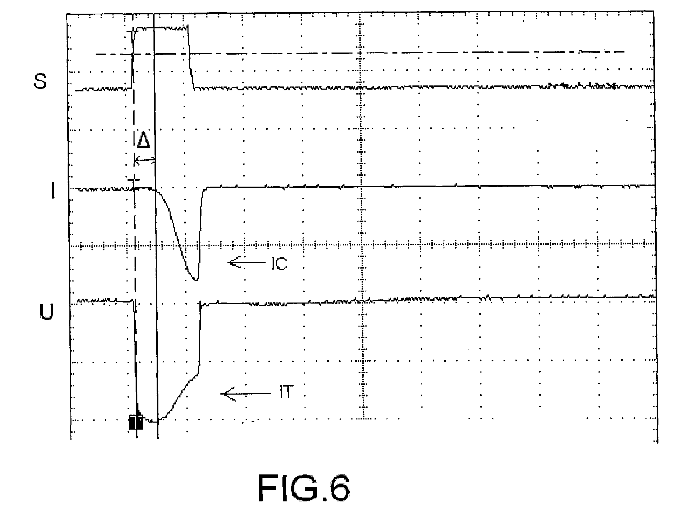

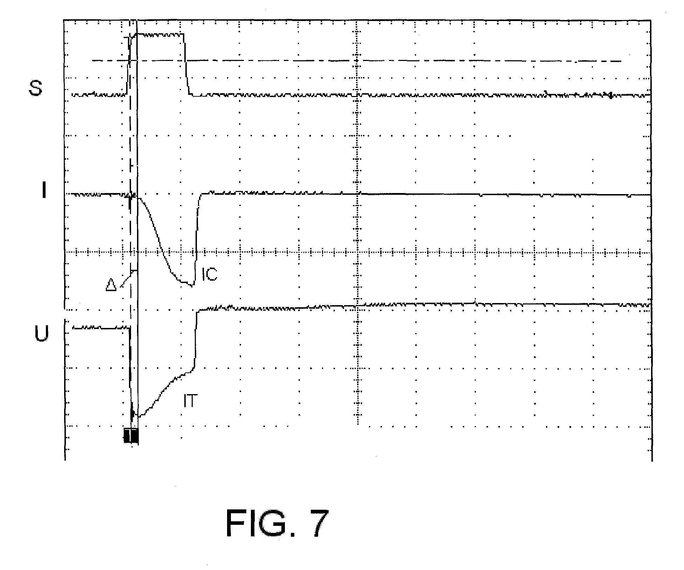

En référence à la figure 6 (f=100Hz), en absence de préionisation l'impulsion de courant se développe de manière plus importante que pour le cas de la figure 4 (f=50Hz), cependant comparativement à un fonctionnement avec la même fréquence de répétition (f=50Hz) et avec préionisation (figure 7), l'impulsion de courant se fait plus tardivement (Figure 6 : Δ= 3,6µs /Figure 7 : Δ= 1,2µs). En l'absence de préionisation, la densité de charges libres est très faible et le temps nécessaire pour la formation d'un plasma de densité suffisante pour donner lieu à un courant utilisable pour la pulvérisation est trop long. La préionisation permet d'atteindre beaucoup plus rapidement la phase de saturation du courant magnétron.

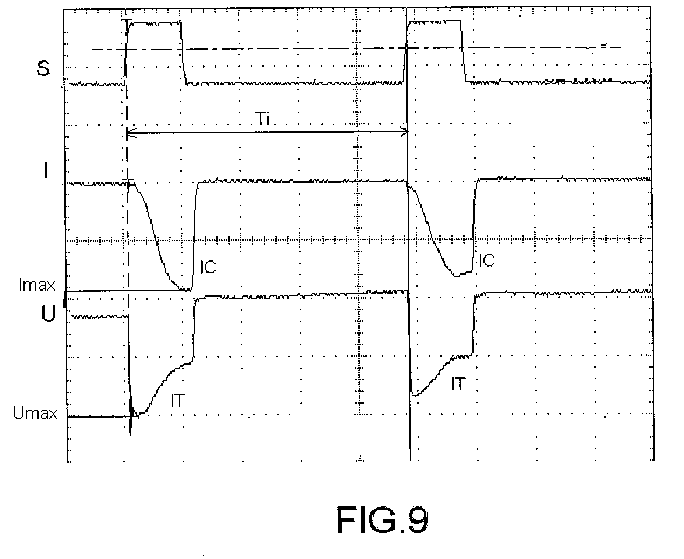

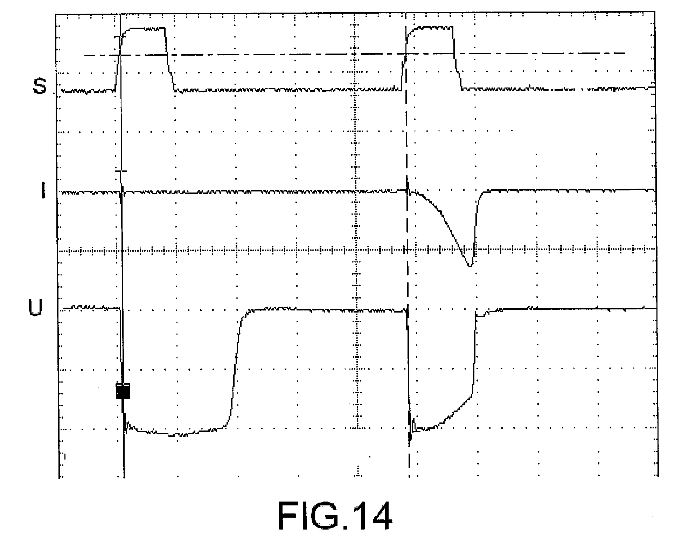

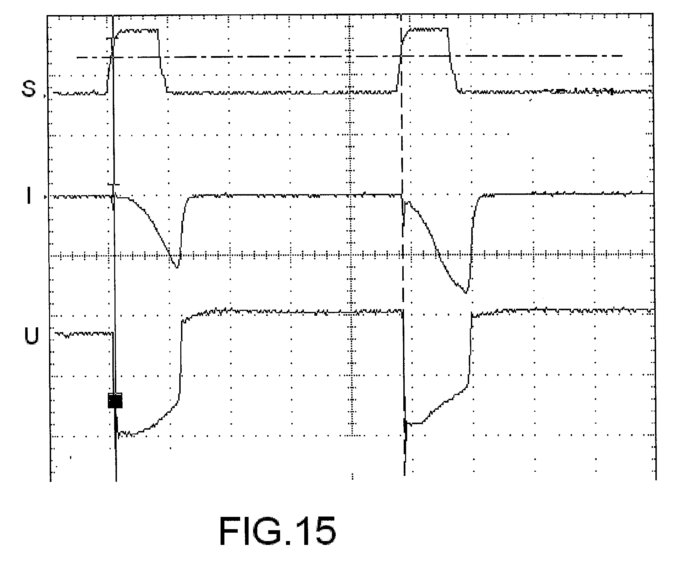

En référence à la figure 8, en régime de double impulsion sans préionisation, la première impulsion de courant intervient tardivement et présente de ce fait une très faible amplitude (situation comparable à la figure 4 en régime de mono impulsion). Dans le cas de la figure 14 (f= 100Hz, Ti = 23,8*µ*s), on constate même l'absence totale de première impulsion de courant en l'absence de préionisation. Comparativement, en mettant en oeuvre une préionisation (figure 9 et figure 15), on constate le formation d'une première impulsion de courant qui se forme très tôt et qui présente une amplitude importante. De surcroît, avec préionisation, la deuxième impulsion de courant présente avantageusement une amplitude plus importante que la deuxième impulsion de courant générée en l'absence de préionisation.

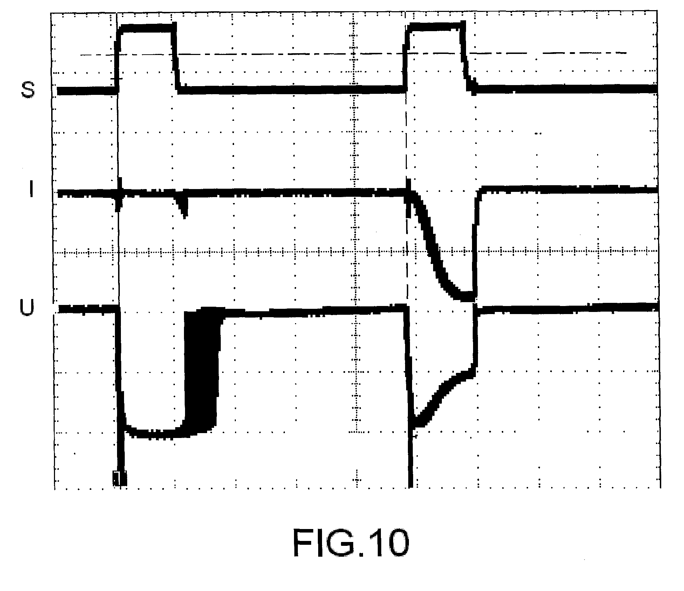

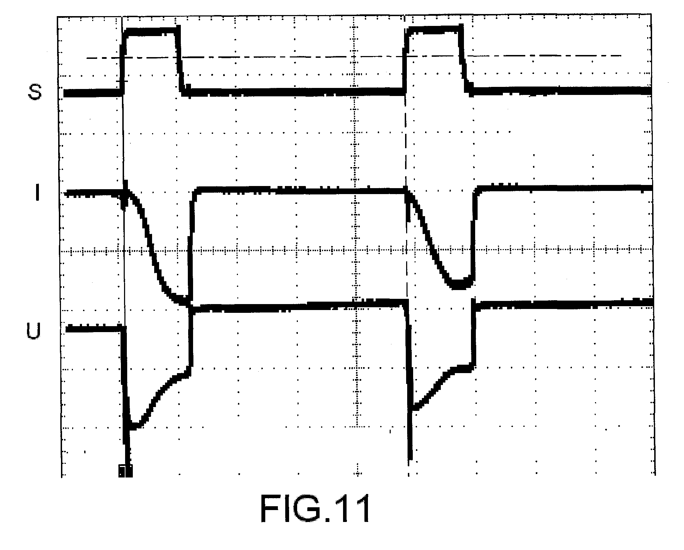

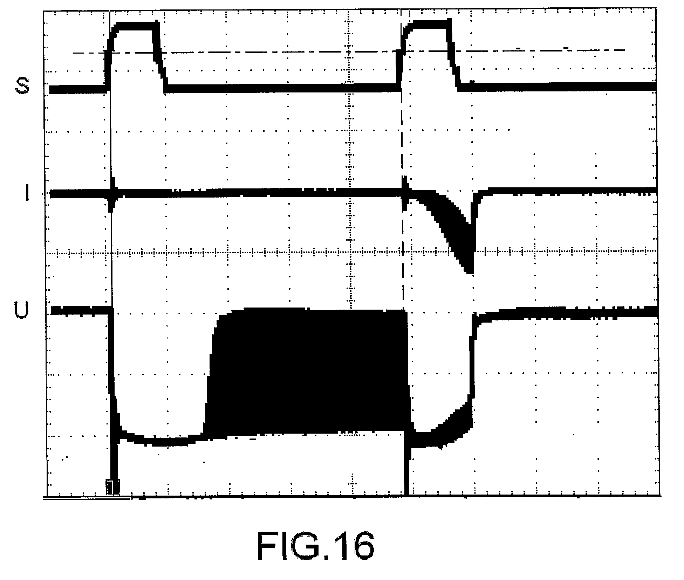

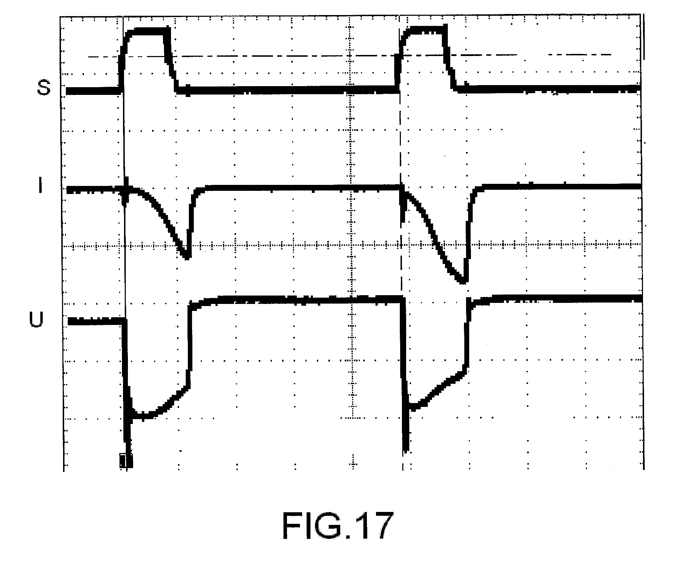

Les figures 10 et 16 (régime de double impulsion sans préionisation / oscilloscope en mode enveloppe) montrent un très forte instabilité dans le temps des impulsions de courant (IC) et de tension (IT), ce qui est nuisible à la qualité et la reproductibilité dans le temps des dépôts de matériau sur le substrat. Comparativement, avec préionisation (figures 11 et 17), on note une très bonne stabilité dans le temps des impulsions de courant et de tension (IC et IT), ce qui avantageusement permet d'obtenir une meilleure reproductibilité et une meilleure stabilité du procédé de dépôt dans le temps.

L'invention n'est pas limitée aux exemples précités de mise en oeuvre, et notamment aux paramètres électriques précédemment décrits pour l'alimentation électrique et le magnétron. Il revient à l'homme du métier de dimensionner et régler au cas par cas l'alimentation électrique pour un magnétron donné, par exemple en observant les courbes de courant (I) et de tension (U) au moyen d'un oscilloscope, et en modifiant la préionisation en sorte d'obtenir les effets recherchés notamment en termes de temps de retard et/ou d'amplitude et/ou de stabilité des impulsions de courant ou encore en sorte d'obtenir le taux d'ionisation recherché pour les vapeurs arrivant sur le substrat. Egalement, la préionisation peut être ajustée de manière à limiter les effets d'empoisonnement de la cible dans le cas de fonctionnement en gaz réactif.

Plus généralement, la préionisation du gaz préalablement à l'application de chaque impulsion de tension IT peut être obtenue par tout moyen connu de l'homme du métier. Plus particulièrement, la préionisation peut être assurée par une fréquence de répétition des impulsions suffisamment élevée de manière à utiliser la densité électrique résiduelle entre deux impulsions successives.

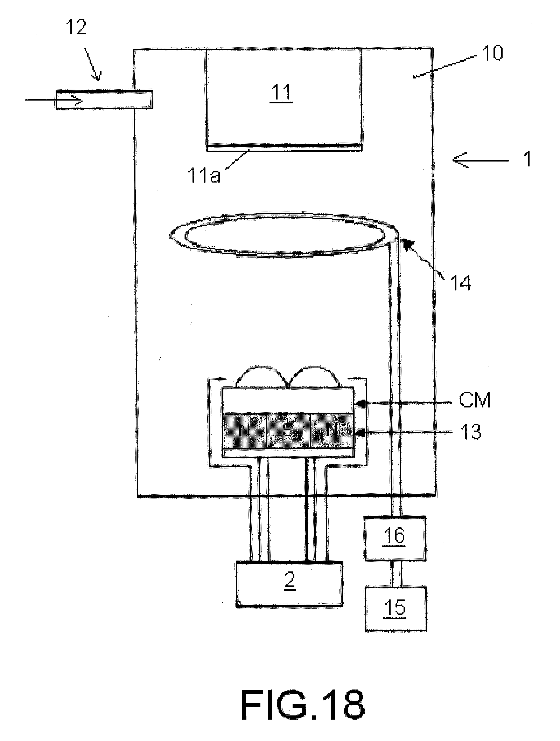

A titre d'exemple non limitatif, la préionisation peut également être obtenue en créant un plasma par excitation RF ou micro-ondes secondaire ou par tout autre moyen permettant d'obtenir une densité électronique de préionisation suffisante (décharge corona, préionisation UV) en plus du plasma impulsionnel principal. Par exemple, en référence à la variante illustrée sur la figure 18, on réalise une excitation RF du gaz au moyen d'une boucle en cuivre 14 placée dans l'enceinte de dépôt à proximité de la cathode magnétron et alimentée au moyen d'un générateur 15 par un courant RF de fréquence prédéfinie. Sur la figure 18, le bloc 16 schématise un réseau d'adaptation d'impédance qui est interposé de manière connue en soi entre le générateur 15 et la boucle 14.

Des résultats comparables à ceux précédemment décrits ont pu être obtenus avec une excitation RF à une fréquence de 13,56 MHz, la distance entre la cathode magnétron CM et la boucle de cuivre 14 étant d'environ 4cm. Le couplage de l'excitation RF n'est pas nécessairement de type inductif, mais peut également être de type capacitif.

Dans une autre variante de réalisation (non représentée), la préionisation peut également être obtenue au moyen de micro-ondes appliquées dans l'enceinte de dépôt, par exemple à une fréquence de 2,45 GHz.

Dans les exemples de figures 1. à 17, la préionisation était obtenue au moyen d'un courant continu de préionisation. Ceci n'est pas limitatif de l'invention. Dans une autre variante, le courant de préionisation pourrait être un courant pulsé, l'essentiel étant que la préionisation du gaz précède l'application de l'impulsion de tension. Dans ce cas, les impulsions de courant de préionisation doivent précéder les impulsions principales de tension (IT). Cette remarque est également valable en cas d'excitation RF ou micro-ondes ou toute autre excitation de préionisation, celles-ci pouvant indifféremment être effectuées en régime continu ou en régime pulsé.

## Revendications

1. Procède de dépôt, dans un réacteur magnétron (1) équipé d'une cathode magnétron (CM), d'au moins un matériau sur un substrat (11a), procédé selon lequel on vaporise ledit matériau, par pulvérisation cathodique magnétron, à l'aide d'un gaz qui est ionisé en régime impulsionnel en appliquant sur la cathode magnétron (CM) des d'impulsions de tension principales (IT), **caractérisé en ce que** préalablement à chaque impulsion de tension principale (IT), on réalise une préionisation dudit gaz.

2. Procède selon la revendication 1 **caractérisé en ce que** le taux d'ionisation des vapeurs mesuré au voisinage du substrat est supérieur à 10% et de préférence supérieur à 70%.

3. Procédé selon la revendication 1 ou 2 **caractérisé en ce que** la préionisation du gaz est obtenue en appliquant sur la cathode magnétron (CM) une tension de préionisation.

4. Procédé selon la revendication 3 **caractérisé en ce que** la tension de préionisation est continue.

5. Procédé selon l'une des revendications 4 **caractérisé en ce que** la densité du courant de préionisation au niveau de la cathode magnétron est comprise entre 0,05 mA/cm² et 100 mA/cm² .

6. Procédé selon l'une des revendications 1 ou 2 **caractérisé en ce que** la préionisation est assurée par une fréquence de répétition des impulsions suffisamment élevée pour former une impulsion de courant stable à chaque impulsion de tension.

7. Procédé selon la revendication 1 ou 2 **caractérisé en ce que** la préionisation du gaz est obtenue par excitation RF du gaz.

8. Procédé selon la revendication 1 ou 2 **caractérisé en ce que** la préionisation du gaz est obtenue par excitation micro-ondes du gaz.

9. Procédé selon l'une quelconque des revendications 1 ou 2 **caractérisé en ce que** les impulsions de tension principales sont générées par trains successifs d'au moins deux impulsions rapprochées (IT).

10. Procédé selon l'une quelconque des revendications 1. à 9 **caractérisé en ce que** la durée (ti) des impulsions de tension principales (IT) est inférieure à 50 *µ*s, plus particulièrement inférieure à 20*µ*s, et de préférence comprise entre 1*µ*s et 10*µ*s.

11. Procédé selon l'une quelconque des revendications 1 à 10 **caractérisé en ce que** la fréquence (f) des impulsions (régime mono impulsion) ou des trains d'impulsions rapprochées est inférieure ou égale à 100kHz, et de préférence supérieure à 50 Hz.

12. Procédé selon l'une quelconque des revendications 1 à 12 **caractérisé en ce que** la durée (Td) de décroissance de l'impulsion de courant (IC), après coupure de l'impulsion de tension principale (IT), est inférieure à 5*µ*s, et de préférence inférieure à 1*µ*s.

13. Alimentation électrique impulsionnelle (2) pour réacteur magnétron (1) et comportant une sortie (Out) destinée à être raccordée à la cathode (CM) du réacteur magnétron, **caractérisée en ce que**lle comporte des premiers moyens permettant de générer sur la sortie (Out) des impulsions de tension principales (IT), et des deuxièmes moyens permettant de générer une tension de préionisation sur la sortie (Out) simultanément aux impulsions de tension principales (IT).

14. Alimentation selon la revendication 13 **caractérisée en ce que** les premiers moyens pour la génération des impulsions de tension principales comportent :
- une source de tension continue (1),
- des moyens (S0, G1, T1) de génération d'impulsions de commande,
- des moyens de commutation (T) qui sont montés entre la source de tension continue (S1) et la sortie (Out), et qui sont commandés par les moyens (S0, G1, T1) de génération d'impulsions de commande,
- une résistance (R1) qui est montée en série entre les moyens de commutation (T) et la sortie (Out), et **en ce que** la jonction (J) entre les moyens de commutation (T) et la résistance (R1) est reliée à la masse.

15. Alimentation selon la revendication 14 pour réacteur magnétron (1) présentant une inductance équivalente (L), **caractérisée en ce que** la résistance (R1) est choisie de telle sorte que (L/R1) est inférieur à 2,5*µ*s et de préférence inférieur à 0,5*µ*s.

16. Alimentation selon l'une des revendications 13 à 15 **caractérisée en ce que** les deuxièmes moyens pour la génération de la tension de préionisation comportent une source de tension continue (S2) reliée à la sortie (Out) via une résistance (R) et une diode de séparation (D) en série.

17. Réacteur magnétron (1) équipé d'une alimentation électrique impulsionnelle visée à l'une quelconque des revendications 13 à 16, la sortie (Out) de l'alimentation (2) étant raccordée à la cathode (CM) du magnétron.
